# EUROPÄISCHE PATENTANMELDUNG

(11) **EP 4 007 461 A1**
(43) Veröffentlichungstag der Anmeldung: **01.06.2022**
(21) Anmeldenummer: 21206756.5
(22) Anmeldetag: 05.11.2021
(51) Int. Cl.: H05K 3/32, H01B 5/16, C09J 9/02, H01R 4/04

(54) **KONTAKTIERANORDNUNG MIT FLÄCHIGEM VERBINDUNGSELEMENT**

(30) Priorität: 05.11.2020 DE 102020213942
(71) Anmelder: Fraunhofer-Gesellschaft zur Förderung der angewandten Forschung e.V., 80686 München (DE)
(72) Erfinder: von Krshiwoblozki, Malte, 13355 Berlin (DE); Yellin, David, 13355 Berlin (DE); Ostmann, Andreas, 13355 Berlin (DE); Dils, Christian, 13355 Berlin (DE)
(74) Vertreter: Pfenning, Meinig & Partner mbB

(57) **Zusammenfassung**

Die vorliegende Erfindung betrifft eine Kontaktieranordnung zum Verbinden mindestens zweier elektrisch leitfähiger Kontaktflächen mittels eines flächigen Verbindungselements, das eine elektrisch und mechanisch stabile Verbindung der beiden Kontaktflächen herstellt.

## Beschreibung

Die vorliegende Erfindung betrifft eine Kontaktieranordnung zum Verbinden mindestens zweier elektrisch leitfähiger Kontaktflächen mittels eines flächigen Verbindungselements, das eine elektrisch und mechanisch stabile Verbindung der beiden Kontaktflächen herstellt. Die Erfindung betrifft außerdem ein Verfahren zum gleichzeitigen mechanischen und elektrischen Verbinden von Kontaktflächen.

Für neu aufkommende Anwendungen von flexibler Elektronik, textilbasierter Elektronik und tragbarer Geräte existiert ein Bedarf an neuen Vorrichtungen und Verfahren, welche einen robusten elektrischen Kontakt zwischen zwei elektrischen Kontaktflächen, beispielsweise von Komponenten und Schaltkreis, ermöglichen.

Die Eigenschaften der neuen Materialien, welche zur Herstellung elektronischer Produkte für besagte neue Anwendungen genutzt werden sind jedoch nicht immer kompatibel mit herkömmlichen Lötverfahren. Ebenso stellen die besagten Anwendungen auch hohe Anforderungen an die elektrische Verbindung hinsichtlich der hohen und dynamischen mechanischen Last, beispielsweise durch Biegen, Dehnen und Knittern, und besonders in Kombination mit Temperaturänderungen. Diese hohen Lasten neigen dazu, herkömmliche Lötverbindungen zu zerstören, ebenso wie alternative Verbindungen wie isotrope, elektrisch leitfähige Klebeverbindungen.

Aufgabe der vorliegenden Erfindung ist es somit, eine Vorrichtung bereitzustellen, die einen elektrischen Kontakt zwischen zwei elektrisch leitfähigen Kontaktflächen herstellt, wobei der Kontakt eine höhere Flexibilität als Lot aufweist, bei niedrigeren Temperaturen als Lötverbindungen herstellbar ist und eine starke mechanische Verbindung zwischen zwei Kontaktflächen bietet.

Die Aufgabe wird bezüglich einer Kontaktieranordnung gemäß Patentansprüchen 1 und 14 und bezüglich eines Verfahrens gemäß Patentanspruch 17 gelöst. Die abhängigen Patentansprüche stellen dabei vorteilhafte Weiterbildungen dar.

In einer ersten Ausführungsform umfasst die erfindungsgemäße Kontaktieranordnung mindestens zwei elektrisch leitfähige Kontaktflächen, die einander zugewandt angeordnet sind und zumindest ein flächiges Verbindungselement, welches zwischen den zwei Kontaktflächen angeordnet ist.

Das flächige Verbindungselement umfasst ferner mindestens ein elektrisch leitfähiges Teil und ein elektrisch isolierendes Material und das mindestens eine zumindest bereichsweise elektrisch leitfähige Teil in dem isolierenden Material eingebettet ist.

Weiterhin verklebt in der erfindungsgemäßen Kontaktieranordnung das elektrisch isolierende Material die zwei Kontaktflächen so miteinander, dass das mindestens eine elektrisch leitfähige Teil durch die zwei Kontaktflächen gestaucht ist und einen elektrischen Kontakt zwischen den zwei Kontaktflächen herstellt.

Flächig im Sinne der Anmeldung bedeutet, dass die Erstreckung des Verbindungselements in zwei Raumrichtungen, welche eine Haupterstreckungsebene des Verbindungselements aufspannen, sehr viel größer ist als in einer dritten, zu den zwei Raumrichtungen orthogonal angeordneten Raumrichtung.

Ein zumindest bereichsweise elektrisch leitfähiges Teil im Sinne der Anmeldung kann neben elektrisch leitfähigen Bereichen auch elektrisch nichtleifähige Bereiche aufweisen. So kann beispielsweise das elektrische leitfähige Teil als textiles Flächengebilde ausgebildet sein, das elektrisch leitfähige und nichtleitfähige Fäden aufweist. Ist das textile Flächengebilde beispielsweise ein Gewebe, so können die Kettfäden elektrisch leitfähig und die Schussfäden elektrisch nichtleitfähig sein. Das zumindest bereichsweise elektrisch leitfähige Teil kann somit neben elektrisch leitfähigen Bestandteilen auch nicht leitfähige Bestandteile umfassen.

Das Verkleben zweier Kontaktflächen im Sinne der Anmeldung kann bedeuten, dass die beiden Kontaktflächen durch die Wirkung eines Klebstoffs aneinander haften, wobei ein Klebstoff vorzugsweise irgendeine nicht-metallische Substanz ist, die in der Lage ist, Werkstoffe durch Oberflächenhaftung (Adhäsion) und seine innere Festigkeit (Kohäsion) mechanisch zu verbinden.

Aufgrund der Elastizität des elektrisch leitfähigen Teils kann die Stauchung durch die zwei Kontaktflächen bewirken, dass eine Kompensationskraft auf die beiden Kontaktflächen wirkt. Dieser Kompensationskraft entgegen können in dieser Ausgestaltung die Klebekräfte wirken, insbesondere Adhäsions- und Kohäsionskraft, des elektrisch isolierenden Materials, so dass ein Gleichgewicht zwischen der Kompensationskraft und den Klebkräften vorliegt.

Die Kompensationskraft kann beispielsweise eine Rückstellkraft des durch die Kontaktflächen gestauchten elektrisch leitfähigen Teils sein.

Ferner stellt das elektrisch leitfähige Teil einen elektrischen Kontakt zwischen den zwei Kontaktflächen her. Dieses Gleichgewicht kann vorzugsweise auch über einen Temperaturbereich von -55° C bis 125°C aufrechterhalten werden, da das beschriebene Gleichgewicht auch bei durch Temperaturerhöhung sich ausdehnenden Materialien besteht.

Die Stauchung des elektrisch leitfähigen Teils erfolgt somit vorzugsweise in einer Richtung, welche sich im Wesentlichen orthogonal zu den Haupterstreckungsebenen der zwei einander zugewandten elektrisch leitfähigen Kontaktflächen erstreckt.

Eine der mindestens zwei elektrisch leitfähigen Kontaktflächen kann mit einem Schaltkreis direkt verbunden sein und eine andere der mindestens zwei Kontaktflächen kann mit einem elektrischen Bauteil direkt verbunden sein, so dass die Kontaktieranordnung eine Stromversorgung des Bauteils ermöglicht, wobei der Stromfluss im Wesentlichen in einer Richtung orthogonal zur Haupterstreckungsebene des Verbindungselements erfolgt.

Ebenso ist es möglich, dass eine der beiden elektrisch leitfähigen Kontaktflächen mit einem flexiblen Schaltkreis direkt verbunden ist und eine andere der mindestens zwei Kontaktflächen ebenfalls mit einem flexiblen Schaltkreis oder einer Leiterplatte direkt verbunden ist. Weiterhin kann jede der beiden Kontaktflächen auch jeweils Teil einer Leiterplatte sein oder direkt mit einer Leiterplatte verbunden sein, so dass die erfindungsgemäße Kontaktieranordnung die beiden Leiterplatten elektrisch miteinander verbindet.

Vorzugsweise ist das elektrisch leitfähige Teil als mindestens ein textiles Flächengebilde ausgebildet, wobei das textile Flächengebilde leitfähige Fäden, Drähte oder Litzen aufweist oder daraus besteht.

Leitfähige Fäden können z.B. elektrische Leiter mit Faden-, Garn-, oder Fasercharakter sein, wie beispielsweise beschichtete Fasern oder metallische Fasern oder Garne bestehend aus nichtleitfähigen und leitfähigen Fasern und/oder Drähten.

Geeigneterweise weist das textile Flächengebilde elektrisch leitfähige Bereiche und nichtleitfähige Bereiche auf.

Weiterhin sind die elektrisch leitfähigen Bereiche vorzugsweise in einem periodischen Muster über das mindestens eine textile Flächengebilde beabstandet verteilt. Das heißt in der Haupterstreckungsebene des flächigen Verbindungselements wiederholen sich die leitfähigen Bereiche in regelmäßigen Abständen, wobei die elektrisch leitfähigen Bereiche nicht miteinander verbunden sind und jeweils von elektrisch nichtleitfähigen Bereichen umgeben sind.

Die Aufteilung des Verbindungselements in elektrisch leitfähige und nichtleifähige Bereiche hat den Vorteil, dass ein oberflächenmontiertes Bauteil (surface mounted device, SMD), beispielsweise durch eine automatische Bestückung mittels eines Bestückungsautomaten, mit einem einzigen Verbindungselement mit einem Schaltungsträger verbindbar ist.

Ist beispielsweise der Abstand der beiden Pole des SMD, welche jeweils eine elektrisch leitfähige Kontaktfläche aufweisen, größer als der Abstand zwischen zwei elektrisch leitfähigen Bereiche des Verbindungselements, so ist es möglich das SMD mit einem einzelnen Verbindungselement mit einen Schaltungsträger zu verbinden und so mit Strom zu versorgen, da innerhalb des Versbindungselements in der Haupterstreckungsebene des Verbindungselements kein elektrischer Stromfluss möglich ist.

Ebenso ist es dadurch mögliche mehrere SMDs mit einem Verbindungselement mit einem Schaltungsträger zu verbinden.

Die elektrisch leitfähigen Bereiche können vorzugsweise die Form von Rechtecken, Quadraten, Kreisen, Tori, Kreuzen, Sechsecken oder Achtecken aufweisen.

Bevorzugterweise ist jeweils mindestens ein elektrisch leitfähiger Bereich zwischen jeweils zweien der einander zugewandten Kontaktflächen angeordnet.

Gemäß einer besonders bevorzugten Ausführungsform ist das textile Flächengebilde als Gewebe, Gelege, Gewirk, Vliesstoff oder Gestrick ausgebildet ist.

Vorzugsweise ist das elektrisch leitfähige Teil als Gewebe mit Kettfäden und Schussfäden ausgebildet ist, und wobei die Schussfäden leitfähige Fäden ausweisen und die Kettfäden nichtleitfähige Fäden aufweisen, oder die Schussfäden nichtleitfähige Fäden aufweisen und die Kettfäden leitfähige Fäden aufweisen.

In einer bevorzugten Ausgestaltung sind dabei die leitfähigen Fäden ausschließlich in Kettrichtung eingebracht, wobei sich elektrisch leitfähige mit elektrisch nicht-leifähigen Fäden abwechseln, so dass die leitfähigen Fäden voneinander elektrisch isoliert in einer Ebene angeordnet sind. Das heißt der direkte Nachbar eines elektrisch leitfähigen Kettfadens in Schussrichtung ist ein elektrisch isolierender Kettfaden.

In einer weiteren vorzugsweisen Ausgestaltung sind dabei die leitfähigen Fäden ausschließlich in Schussrichtung eingebracht, wobei sich elektrisch leitfähige mit elektrisch nicht-leifähigen Fäden abwechseln, so dass die leitfähigen Fäden voneinander elektrisch isoliert in einer Ebene angeordnet sind. Das heißt der direkte Nachbar eines elektrisch leitfähigen Schussfadens in Kettrichtung ist ein elektrisch isolierender Schussfaden.

Dadurch, dass elektrisch leitfähige und nichtleitfähige Fäden alternierend in Kett-oder Schussrichtung angeordnet sind, ist ein Stromfluss innerhalb des Verbindungselements in einer anderen Richtung als der Erstreckungsrichtung der leitfähigen Fäden nicht möglich.

Das elektrisch isolierende Material enthält vorzugweise einen Klebstoff und insbesondere einen Thermoplast, einen Duroplast, einen durch Strahlung vernetzten Klebstoff, ein PDMS Derivat oder einen lösungsmittelbasierter Klebstoff oder kann daraus bestehen.

Ferner ist die Kontaktieranordnung vorzugsweise so gestaltet, dass die Normalenvektoren der zwei Kontaktflächen im Wesentlichen parallel zueinander verlaufen. Geeigneterweise verläuft der Normalenvektor des flächigen Verbindungselements ebenfalls im Wesentlichen parallel zu den Normalenvektoren der zwei Kontaktflächen.

In einer weiteren bevorzugten Ausführung der Kontaktieranordnung ist eine Fläche des flächigen Verbindungselements gleich groß wie oder größer als eine Fläche einer, vorzugsweise jeder, der mindestens zwei einander zugewandten Kontaktflächen ist.

Geeigneterweise ist das elektrisch isolierende Material als Klebefolie oder-film ausgebildet, in welche das mindestens eine elektrisch leitfähige Teil eingebettet ist.

In einer weiteren erfindungsgemäßen Ausgestaltung kann die Kontaktieranordnung mindestens zwei elektrisch leitfähige Kontaktflächen umfassen, die einander zugewandt angeordnet sind, zumindest ein flächiges Verbindungselement, welches zwischen den zwei Kontaktflächen angeordnet ist, wobei das flächige Verbindungselement mindestens ein elektrisch leitfähiges Teil, mindestens ein deformierbares Teil und ein elektrisch isolierendes Material umfasst, und das mindestens eine elektrisch leitfähige Teil und das mindestens eine deformierbare Teil in dem isolierenden Material eingebettet sind, und wobei das elektrisch isolierende Material die zwei Kontaktflächen so miteinander verklebt, dass das mindestens eine deformierbare Teil durch die zwei Kontaktflächen gestaucht ist und das mindestens eine elektrisch leitfähige Teil einen elektrischen Kontakt zwischen den zwei Kontaktflächen herstellt.

Durch eine Verformung des deformierbaren Teils und/oder des elektrisch leitfähigen Teils können in dieser Ausgestaltung Kompensationskräfte erzeugt werden, die den Klebekräften des elektrisch isolierenden Materials entgegenwirken.

Durch diesen Kompensationseffekt kann vorzugsweise ein elektrischer Kontakt mittels des elektrisch leitfähigen Teils über einen Temperaturbereich von -55° C bis 125°C aufrechterhalten werden, da die beschriebene Kräftekompensation auch bei durch Temperaturerhöhung sich ausdehnenden Materialien besteht.

Vorzugsweise umfasst die Vorrichtung weiterhin, dass das mindestens eine elektrisch leitfähige Teil mindestens ein Flüssigmetalltröpfchen umfasst und das mindestens eine deformierbare Teil ein elektrisch leitfähiges oder nichtleitfähiges, textiles Flächengebilde umfasst.

Beispielsweise können die Flüssigmetalltröpfchen Galinstan enthalten oder daraus bestehen, wobei Galinstan aufgrund seiner hohen Oberflächenspannung den Effekt hat, den elektrischen Kontakt zwischen den einander zugewandten Kontaktflächen nach einer hohen Lasteinwirkung wiederherstellen zu können.

Dadurch, dass das deformierbare Teil vorzugweise als ein textiles Flächengebilde ausgebildet ist, kann ein Zerfließen des mindestens einen Flüssigmetalltröpfchens in der Haupterstreckungsebene des Verbindungselements während des Verklebens der beiden Kontaktflächen verhindert werden.

Weiterhin umfasst die Kontaktieranordnung vorzugsweise, dass das elektrisch leitfähige Teil mindestens ein Metallpartikel, insbesondere ein Silberpartikel, aufweist und das mindestens eine deformierbare Teil Polymere aufweist.

Die vorliegende Erfindung betrifft zudem ein Verfahren zum gleichzeitigen mechanischen und elektrischen Verbinden von mindesten zwei einander zugewandten elektrisch leitfähigen Kontaktflächen mittels eines flächigen Verbindungselements, welches zwischen den zwei Kontaktflächen angeordnet ist.

Das flächige Verbindungselement weist mindestens ein zumindest bereichsweise elektrisch leitfähiges Teil und ein elektrisch isolierendes Material auf. Weiterhin ist das mindestens eine elektrisch leitfähige Teil in dem elektrisch isolierenden Material eingebettet, wobei das elektrisch isolierende Material während eines gegeneinander Pressens der zwei Kontaktflächen in einem fließfähigen Zustand ist und anschließend in einen festen Zustand überführt wird, so dass eine Stauchung des elektrisch leitfähigen Teils durch die zwei Kontaktflächen aufrechterhalten wird und ein elektrischer Kontakt der zwei Kontaktflächen durch das elektrisch leitfähige Teil erhalten wird.

Das Überführen des isolierenden Materials in den fließfähigen Zustand erfolgt vorzugsweise durch Wärmezufuhr. Die Wärmezufuhr kann durch Temperaturerhöhung des umgebenden Raumes, aber auch gezielt durch Einwirkung von Infrarot-oder Lichtstrahlen, Ultraschall sowie magnetischer oder elektrischer Felder erfolgen.

Es ist gleichwohl möglich, den fließfähigen Zustand des Klebstoffs auf chemischem Wege herbeizuführen. So kann dem isolierenden Material ein flüchtiges Lösungsmittel hinzugefügt werden, das den fließfähigen Zustand bewirkt. Nachdem der elektrische Kontakt durch Druckaufbringung hergestellt ist, verdampft das Lösungsmittel unter Aufrechterhaltung des Drucks, bis das isolierende Material wieder verfestigt ist.

Das Verfahren umfasst vorzugsweise weiterhin, dass das flächige Verbindungselement vor dem Verbinden der zwei elektrisch leitfähigen Kontaktflächen von einem Band abgetrennt wird.

Dass das Verbindungselement vorzugsweise von einem Band abgetrennt wird, kann im Sinne der Anmeldung auch bedeuten, dass das Verbindungselement auf dem Band mit einer Seite aufgebracht ist und vor dem Verbinden von dem Band abgelöst wird.

Der Vorteil dieser Ausgestaltung ist, dass ein einzelnes Verbindungselement nach dem Abtrennen vom Band beispielsweise mit einem Bestückungsautomaten verarbeitbar ist. Auf diese Weise können beispielsweise Verbindungselemente auf einem Schaltungsträger platziert werden bevor ein SMD auf dem Schaltungsträger montiert wird. Alternativ können die Verbindungselemente an den SMDs fixiert werden, um anschließend in einem Prozessschritt auf dem Schaltungsträger platziert zu werden.

Im Folgenden soll die Erfindung anhand einiger Figuren beispielhaft erläutert werden. Gleiche oder entsprechende Bezugszeichen kennzeichnen dabei gleiche oder entsprechende Merkmale, so dass deren Erläuterung gegebenenfalls nicht wiederholt wird. Die nachfolgenden Beispiele weisen eine Vielzahl zusätzlicher Merkmale auf, welche die Erfindung weiterhin verbessern können. Die in den Beispielen beschriebenen Merkmale können darüber hinaus unabhängig von den entsprechenden Beispielen realisiert werden und zwischen verschiedenen Beispielen kombiniert werden. Die vorliegende Erfindung ist nicht auf die in den Figuren und Beispielen gezeigten spezifischen Ausführungsform und Merkmale beschränkt.

Es zeigt
Figur 1(a) eine Seitenansicht einer beispielhafte Ausgestaltung einer erfindungsgemäßen Vorrichtung in Explosionsdarstellung,
Figur 1(b) eine Seitenansicht der in Figur 1(a) dargestellten Vorrichtung in montiertem Zustand,
Figur 2(a) zeigt eine weitere beispielhafte Ausgestaltung eines Verbindungselements in einer Draufsicht,
Figur 2(b) zeigt eine weitere beispielhafte Ausgestaltung eines Verbindungselements in einer Draufsicht,
Figur 2(c) zeigt eine weitere beispielhafte Ausgestaltung eines Verbindungselements in einer Draufsicht,
Figur 3(a) zeigt eine weitere beispielhafte Ausgestaltung eines Verbindungselements in einer Draufsicht,
Figur 3(b) zeigt eine weitere beispielhafte Ausgestaltung eines Verbindungselements in einer Draufsicht,
Figur 3(c) zeigt das in Figur 3(b) dargestellte Verbindungselement entlang eines Schnittes parallel zu einer langen Seite des Verbindungselementes,
Figur 3(d) zeigt eine Anordnung mehrerer der in Figur 3(b) gezeigten Verbindungselemente 10 auf einem Band in einer Draufsicht.
Figur 4(a) zeigt einen Querschnitt eines weiteren beispielhaften Verbindungselements 10 im unmontierten Zustand.
In Figur 4(b) wird ein Querschnitt des in Figur 4(a) beispielhaft gezeigten Verbindungselements 10 im montierten Zustand dargestellt.
Figur 5(a) zeigt einen Querschnitt eines weiteren beispielhaften Verbindungselements 10 im unmontierten Zustand.
In Figur 5(b) wird ein Querschnitt des in Figur 5(a) beispielhaft gezeigten Verbindungselements 10 im montierten Zustand dargestellt.
Figur 6(a) zeigt einen Querschnitt eines weiteren beispielhaften Verbindungselements 10 im unmontierten Zustand.
Figur 6(b) wird ein Querschnitt des in Figur 6(a) beispielhaft gezeigten Verbindungselements 10 im montierten Zustand dargestellt.
Figur 7(a) zeigt einen Querschnitt eines weiteren beispielhaften Verbindungselements 10 im unmontierten Zustand.
Figur 7(b) wird ein Querschnitt des in Figur 7(a) beispielhaft gezeigten Verbindungselements 10 im montierten Zustand dargestellt.
Figur 8(a) zeigt einen Querschnitt eines weiteren beispielhaften Verbindungselements 10 im unmontierten Zustand.
Figur 8(b) wird ein Querschnitt des in Figur 8(a) beispielhaft gezeigten Verbindungselements 10 im montierten Zustand dargestellt.
Figur 9(a) zeigt einen Querschnitt eines weiteren beispielhaften Verbindungselements 10 im unmontierten Zustand.
Figur 9(b) wird ein Querschnitt des in Figur 9(a) beispielhaft gezeigten Verbindungselements 10 im montierten Zustand dargestellt.

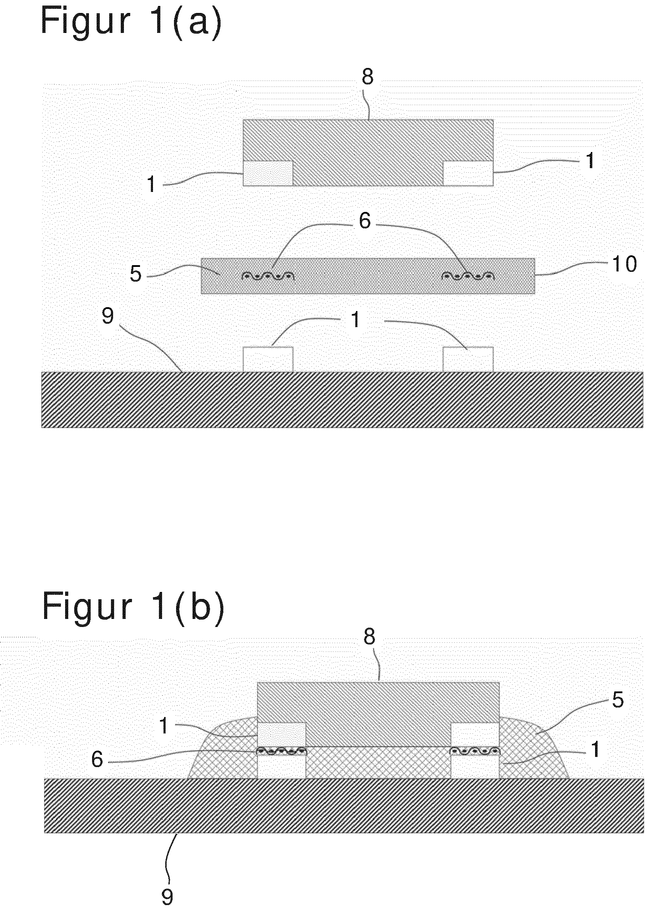

Figur 1(a) zeigt eine Seitendarstellung einer beispielhaften Ausgestaltung einer erfindungsgemäßen Vorrichtung in Explosionsdarstellung. Insgesamt weist die gezeigte Kontaktieranordnung vier Kontaktflächen 1 auf, von denen jeweils zwei Kontaktflächen 1 einander zugewandt angeordnet sind, wobei die Haupterstreckungsebenen der Kontaktflächen 1 senkrecht zu der Darstellungsebene stehen und im Wesentlichen parallel zueinander verlaufen.

Ein flächiges Verbindungselement 10 ist zwischen den Kontaktflächen 1 angeordnet und die Normalenvektoren des Verbindungselementes 10 und der Kontaktflächen 1 verlaufen im Wesentlichen parallel zueinander in der Darstellungsebene. Das flächige Verbindungselement 10 weist zwei zumindest bereichsweise elektrisch leitfähige Teile 6 auf, welche jeweils als textiles Flächengebilde ausgebildet sind. Die textilen Flächengebilde 6 sind in einem elektrisch isolierenden Material 5 eingebettet und zwischen den zwei sich jeweils zugewandten Kontaktflächen 1 angeordnet.

Ferner sind die gezeigten textilen Flächengebilde 6 als Gewebe ausgebildet, wobei die Kettfäden in der Darstellungsebene verlaufen und die Schussfäden in einer zur Darstellungsebene orthogonalen Ebene verlaufen. In der dargestellten Vorrichtung können aufgrund des Umstands, dass die elektrisch leitfähigen Teile 6 im Wesentlichen deckungsgleich mit den Kontaktflächen 1 angeordnet sind, Fäden leitfähig sein. Alternativ kann das Gewebe dabei so gestaltet, dass entweder die Schussfäden leitfähige Fäden 2 aufweisen und die Kettfäden nichtleitfähige Fäden 3 aufweisen oder aber die Schussfäden nichtleitfähige Fäden 3 ausweisen und die Kettfäden leitfähige Fäden 2 aufweisen.

Alternativ zu der hier gezeigten Ausgestaltung kann das textile Flächengebilde 6 auch als Gelege, Gewirk, Vliesstoff oder Gestrick ausgebildet sein.

Die zwei Kontaktflächen 1, welche unterhalb des Verbindungselements 10 angeordnet sind, sind auf einem Schaltungsträger 9 aufgebracht. Die zwei Kontaktflächen 1 welche oberhalb des Verbindungselements 10 angeordnet sind, sind Teil eines elektrischen Bauelements 8, beispielsweise eines SMD-Bauelements, welches im montierten Zustand über den Schaltungsträger 9 mit Strom versorgt werden kann.

Figur 1(b) eine Seitenansicht der in Figur 1(a) dargestellten Vorrichtung in montiertem Zustand. Das elektrisch isolierende Material 5 verklebt die zwei jeweils einander zugewandt angeordneten Kontaktflächen 1 so miteinander, dass das jeweils eine zumindest bereichsweise elektrisch leitfähige Teil 6, welches zwischen den zwei einander zugewandten Kontaktflächen 1 angeordnet ist, durch die zwei Kontaktflächen 1 gestaucht wird und einen elektrischen Kontakt zwischen den zwei Kontaktflächen 1 herstellt. Die Stauchung des elektrisch leitfähigen Teils 6 erfolgt dabei im Wesentlichen in einer Richtung, welche orthogonal zu den Haupterstreckungsebenen der Kontaktflächen 1 verläuft.

Mittels des Schaltungsträgers 9 kann somit das elektrische Bauelement 8 über die durch das Verbindungselement 10 hergestellten elektrischen Kontakte mit Strom versorgt werden oder eine Spannung angelegt werden.

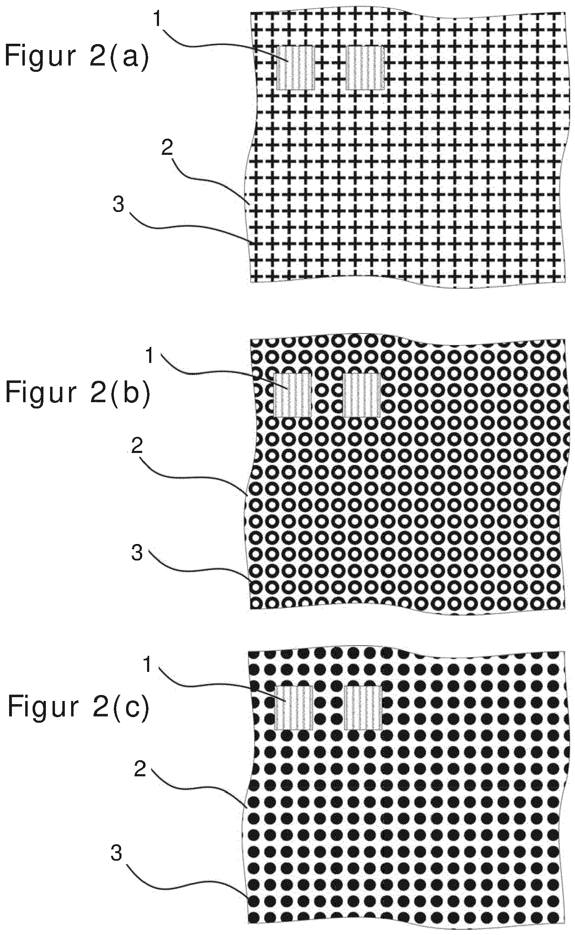

Figur 2(a) zeigt eine weitere beispielhafte Ausgestaltung eines Verbindungselements 10 in einer Draufsicht. Ein elektrisch leitfähiges Teil 6 ist als textiles Flächengebilde ausgestaltet und erstreckt sich im Wesentlichen über die gesamte Erstreckungsfläche des Verbindungselements 10. Leitfähige Bereiche 3 weisen eine Kreuzform auf und sind in einem sich wiederholenden Muster in der Haupterstreckungsebene des Verbindungselements 10 beabstandet verteilt. Bereiche, welche die leitfähigen Bereiche 3 umgeben, sind nichtleitfähige Bereiche 2 und weisen nichtleitfähiges Textil 4b auf.

Zwei elektrisch leitfähige Kontaktflächen 1 sind auf dem Verbindungselement 10 angeordnet, wobei sich eine Kontaktfläche 1 jeweils über mehrere leitfähige Bereiche 3 vollständig oder zumindest teilweise erstreckt. Zwei elektrisch leitfähige Kontaktflächen 1, welche nicht gezeigt sind, können den gezeigten Kontaktflächen auf der anderen Seite des Verbindungselements 10 zugewandt angeordnet sein, so dass mindestens jeweils ein elektrisch leitfähiger Bereich 3 zwischen jeweils zwei der einander zugewandten Kontaktflächen 1 angeordnet ist.

Figur 2(b) zeigt eine weitere beispielhafte Ausgestaltung eines Verbindungselements 10 in einer Draufsicht. Die gezeigte Ausgestaltung ist im Wesentlichen identisch zu der in Figur 2(a) dargestellten Ausgestaltung mit dem Unterschied, dass die leitfähigen Bereiche 3 eine Ringform aufweisen.

Figur 2(c) zeigt eine weitere beispielhafte Ausgestaltung eines Verbindungselements 10 in einer Draufsicht. Die gezeigte Ausgestaltung ist im Wesentlichen identisch zu der in Figur 2(a) dargestellten Ausgestaltung mit dem Unterschied, dass die leitfähigen Bereiche 3 die Form von Kreisscheiben aufweisen.

Neben den in Figuren 2(a) bis 2(c) gezeigten Beispiele können die leitfähigen Bereiche auch die Form von Rechtecken, Quadraten, Tori, Sechsecken oder Achtecken aufweisen.

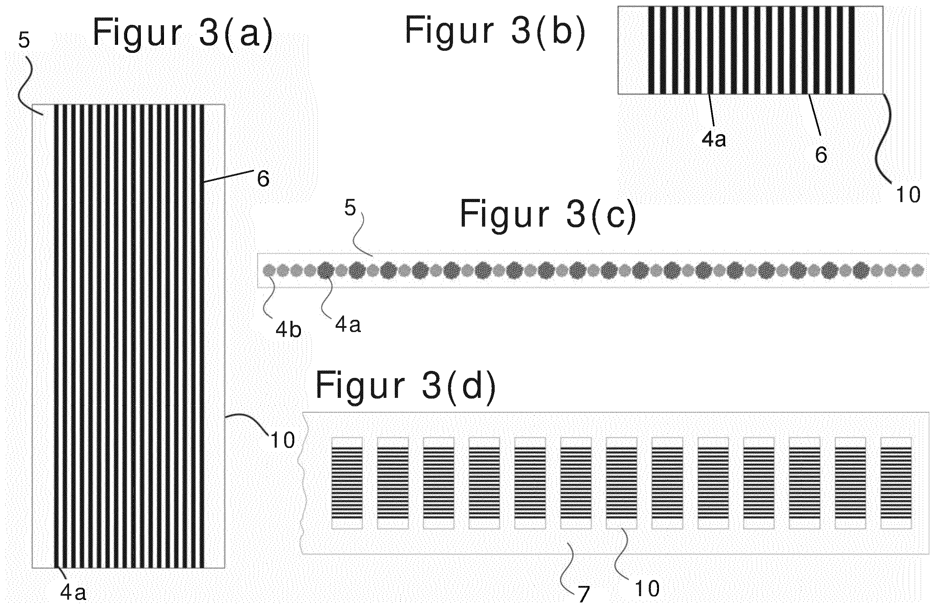

Figur 3(a) zeigt eine weitere beispielhafte Ausgestaltung eines Verbindungselements 10 in einer Draufsicht. Das flächige Verbindungselement 10 weist eine rechteckige Form auf, wobei ein elektrisch leitfähiges Teil 6 als leitfähige Fäden 4a ausgestaltet sind, welche parallel zueinander und parallel zu einer langen Seite des Verbindungselements 10 verlaufen. In beiden Endbereichen einer kurzen Seite des Verbindungselements 10 sind keine leitfähigen Fäden angeordnet, wobei sich die Endbereiche über die gesamte Länge der langen Seiten des Verbindungselements 10 erstrecken.

Figur 3(b) zeigt eine weitere beispielhafte Ausgestaltung eines Verbindungselements 10 in einer Draufsicht. Das flächige Verbindungselement 10 weist eine rechteckige Form auf, wobei ein elektrisch leitfähiges Teil 6 als leitfähige Fäden 4a ausgestaltet sind, welche parallel zueinander und parallel zu einer kurzen Seite des Verbindungselements 10 verlaufen. In beiden Endbereichen einer langen Seite des Verbindungselements 10 sind keine leitfähigen Fäden 4a angeordnet, wobei sich die Endbereiche über die gesamte der kurzen Seiten des Verbindungselements 10 erstrecken.

Figur 3(c) zeigt das in Figur 3(b) dargestellte Verbindungselement in einer Schnittebene parallel zu einer langen Seite des Verbindungselementes und orthogonal zu der Darstellungsebene in Figur 3(b). In den Endbereichen sind elektrisch nichtleitfähige Fäden 4b angeordnet. In dem Bereich zwischen den beiden Endbereichen sind elektrisch leitfähige 4a und nicht-leitfähige Fäden 4b abwechselnd angeordnet, so dass zwischen zwei parallel zueinander verlaufenden elektrisch leifähigen Fäden 4a kein elektrischer Kontakt besteht. Die Anordnung der Fäden hat somit zur Folge, dass innerhalb des Verbindungselements ein Stromfluss in einer Richtung orthogonal zur Erstreckungsrichtung der elektrisch leitfähigen Fäden 4a nicht möglich ist.

In den in Figuren 3(a) bis 3(c) gezeigten Beispielen ist das textile Flächengebilde im Wesentlichen als ein Gelege ausgebildet, wobei die Fäden von dem sie umgebenden elektrisch isolierenden Material 5 in ihrer Position gehalten werden. Das elektrisch isolierende Material 5 kann dabei einen Klebstoff und insbesondere einen Thermoplast, einen Duroplast, einen durch Strahlung vernetzen Klebstoff, ein PDMS Derivat oder einen lösungsmittelbasierten Klebstoff enthalten oder daraus bestehen. Ebenso kann das elektrisch isolierende Material 5 als Klebefolie oder Klebefilm ausgebildet sein.

Figur 3(d) zeigt eine Anordnung mehrerer der in Figur 3(b) gezeigten Verbindungselemente 10. Die Verbindungselemente 10 sind dabei parallel zueinander entlang ihrer langen Seiten auf einem Ablöseband (release tape) 7 angeordnet. Die dargestellte Anordnung erlaubt eine einfache Ablösung der Verbindungselemente 10 für die automatische Bestückung (pick and place) mittels eines Bestückungsautomaten.

Die in Figuren 3(a) bis 3(d) dargestellten Beispiele von Verbindungselementen 10 können dabei die gleiche oder eine größere Fläche haben, als die Fläche einer oder beider der einander zugewandten Kontaktflächen 1.

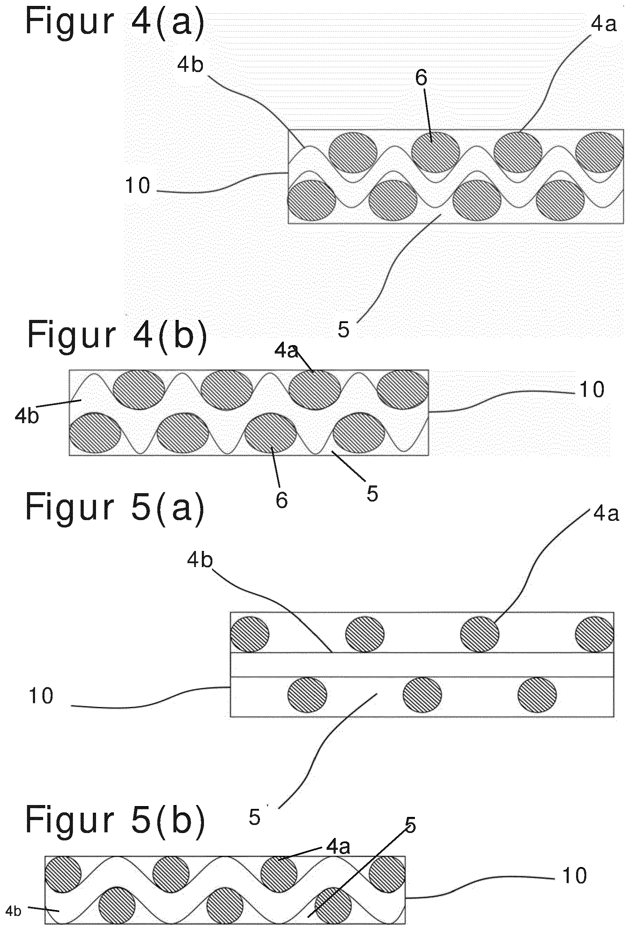

Figur 4(a) zeigt einen Querschnitt eines weiteren beispielhaften Verbindungselements 10 im unmontierten Zustand. Ein zumindest bereichsweise elektrisch leitfähiges Teil 6 ist als Gewebe ausgebildet, wobei das Gewebe elektrisch nicht leitfähigen Fäden 4b und elektrisch leitfähige Fäden 4a aufweist. In dem gezeigten Querschnitt verläuft ein wellenförmiger, elektrisch nicht leitfähiger Faden 4b innerhalb des Verbindungselements in der Darstellungsebene. Elektrische leitfähige Fäden 4a sind jeweils oberhalb bzw. unterhalb der Scheitelpunkte des wellenförmigen nichtleitfähigen Fadens angeordnet. Eine Haupterstreckungsrichtung der leitfähigen Fäden 4a ist dabei im Wesentlichen orthogonal zur Haupterstreckungsrichtung des nichtleifähigen Fadens 4b. Die elektrisch nicht leitfähigen Fäden 4b weisen dabei ein höheren Elastizitätsmodul auf als die elektrisch leitfähigen Fäden.

In Figur 4(b) wird ein Querschnitt des in Figur 4(a) beispielhaft gezeigten Verbindungselements 10 im montierten Zustand dargestellt. Das heißt das gezeigte Verbindungselement 10 wird durch miteinander verklebten Kontaktflächen komprimiert, wobei die Kontaktflächen ober- und unterhalb des Verbindungselements 10 angeordnet sind und in der Figur nicht abgebildet sind. Figuren 5(b), 6(b), 7(b), 8(b) und 9(b) stellen ebenso derartig montierte Verbindungselemente 10 dar, wobei die Kontaktflächen oberhalb und unterhalb der jeweiligen Verbindungselemente 10 nicht abgebildet sind.

Durch das Verkleben wird das elektrische leitfähige Teil 6 in einer Richtung orthogonal zur Haupterstreckungsebene des Verbindungselements 10 gestaucht, wobei aufgrund ihres höheren Elastizitätsmoduls die elektrisch nicht leitfähigen Fäden 4b verformt werden und die in Figur 4(a) dargestellten Form der elektrisch leifähigen Fäden 4a im Wesentlichen unverändert bleibt. Ferner sei darauf hingewiesen, dass die in Figuren 4(a), 4(b), 5(a), 5(b), 7(a) und 7(b) gezeigten textilen Flächengebilde als Gewebe ausgebildet sind. Die dargestellten leitfähigen Fäden 4a, deren Haupterstreckungsrichtung im Wesentlichen orthogonal zur Darstellungsebene verläuft, sind somit wellenförmig bzw. gewellt. Das bedeutet, dass ein leitfähiger Faden 4a, der beispielsweise in Figur 4(b) an der Oberseite des Verbindungselements 10 und oberhalb des gezeigten nicht leitfähigen Fadens 4b angeordnet ist, an beiden nicht leitfähigen Fäden, welche benachbart zum dargestellten nichtleitfähigen Faden angeordnet sind und sich in einer Richtung parallel zu diesem erstrecken, an der Unterseite des Verbindungselements 10 und unterhalb der nichtleitfähigen Fäden angeordnet ist. Die leitfähigen Fäden 4a sind also entlang ihrer Haupterstreckungsrichtung alternierend in Kontakt mit den Kontaktflächen zwischen denen das Verbindungselement angeordnet ist. Auf diese Weise wird ein elektrischer Kontakt zwischen den beiden Kontaktflächen hergestellt.

Figur 5(a) zeigt einen Querschnitt eines weiteren beispielhaften Verbindungselements 10 im unmontierten Zustand. Vier leitfähige Fäden 4a sind jeweils oberhalb und unterhalb eines nicht leitfähigen Fadens 4b angeordnet, wobei eine Haupterstreckungsrichtung der leitfähigen Fäden 4a orthogonal zur Darstellungsebene verläuft. Ein nichtleitfähiger Faden 4b, welche orthogonal zu den leitfähigen Fäden 4a angeordnet ist, verläuft im Wesentlichen gerade innerhalb der Darstellungsebene.

In Figur 5(b) wird ein Querschnitt des in Figur 5(a) beispielhaft gezeigten Verbindungselements 10 im montierten Zustand dargestellt. Im montierten Zustand sind die leitfähigen Fäden 4a alternierend in Kontakt mit den Kontaktflächen zwischen denen das Verbindungselement angeordnet ist, wie in Bezug auf Figur 4(b) ausgeführt ist. Weiterhin wird durch das Verkleben ebenfalls der elektrisch nicht leitfähige Faden 4b wellenförmig verformt, wobei eine Durchmesser des Fadens im Wesentlichen unverändert bleibt.

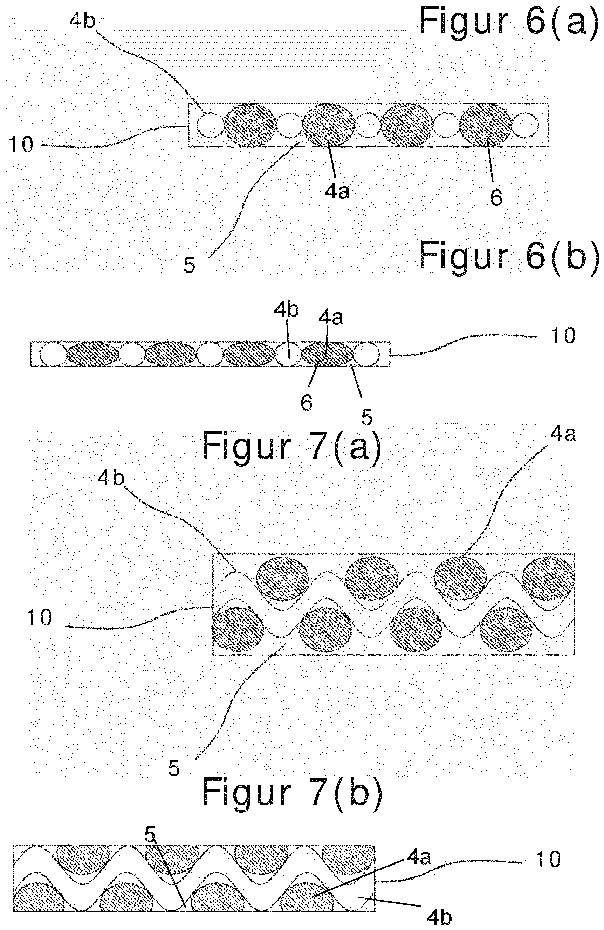

Figur 6(a) zeigt einen Querschnitt eines weiteren beispielhaften Verbindungselements 10 im unmontierten Zustand. In dem dargestellten Verbindungselement 10 ist ein elektrisch leitfähiges Teil 6 als Gelege ausgebildet. Elektrisch leitfähige 4a und elektrisch nicht leitfähige Fäden 4b sind abwechselnd angeordnet in einer Richtung der Haupterstreckungsebene des Verbindungselements 10 und verlaufen parallel zueinander in der anderen Richtung der Haupterstreckungsebene des Verbindungselements 10. Die elektrisch leitfähigen Fäden 4a weisen einen größeren Durchmesser als die elektrisch nicht leitfähigen Fäden 4b auf.

Figur 6(b) wird ein Querschnitt des in Figur 6(a) beispielhaft gezeigten Verbindungselements 10 im montierten Zustand dargestellt. Das heißt das gezeigte Verbindungselement 10 wird durch miteinander verklebten Kontaktflächen komprimiert, wobei die Kontaktflächen ober- und unterhalb des Verbindungselements 10 angeordnet sind und in der Figur nicht abgebildet sind. Durch das Verkleben wird das zumindest bereichsweise elektrisch leitfähige Teil 6 in einer Richtung orthogonal zur Haupterstreckungsebene des Verbindungselements 10 gestaucht, wobei aufgrund ihres größeren Durchmessers die elektrisch leitfähigen Fäden 4a verformt werden und die Form der elektrisch nicht leifähigen Fäden 4b im Wesentlichen unverändert bleibt.

Figur 7(a) zeigt einen Querschnitt eines weiteren beispielhaften Verbindungselements 10 im unmontierten Zustand. Die Anordnung des Verbindungselements 10 ist im Wesentlichen identisch zu dem in Figur 4(a) gezeigten Verbindungselement 10, allerdings weisen in dem gezeigten Verbindungselement 10 die elektrisch leitfähigen Fäden 4a ein höheres Elastizitätsmodul auf als nicht leitfähigen Fäden 4b.

Figur 7(b) wird ein Querschnitt des in Figur 7(a) beispielhaft gezeigten Verbindungselements 10 im montierten Zustand dargestellt. Aufgrund des höheren Elastizitätsmoduls der leitfähigen Fäden 4a werden diese durch das Verkleben elastisch verformt, während der nichtleitfähige Faden 4b im Wesentlichen die selbe Form aufweist wie im unmontierten Zustand, der in Figur 7(a) dargestellt ist.

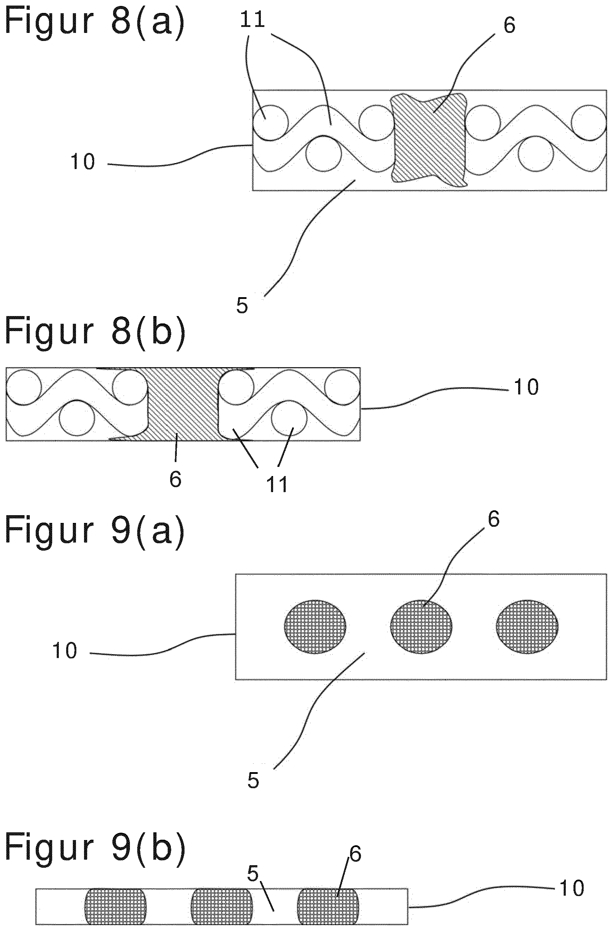

Figur 8(a) zeigt einen Querschnitt eines weiteren beispielhaften Verbindungselements 10 im unmontierten Zustand. Ein deformierbares Teil 11, welches als ein Gewebe ausgebildet ist, und ein elektrisch leitfähiges Teil 6 in Form eines Flüssigmetalltropfens sind in einem elektrisch isolierenden Material 5 eingebettet.

In Figur 8(b) wird ein Querschnitt des in Figur 8(a) beispielhaft gezeigten Verbindungselements 10 im montierten Zustand dargestellt. Durch das Verkleben kann das deformierbare Teil 11 verformt werden. Ebenso stellt der Flüssigmetalltropfen einen elektrischen Kontakt zwischen den beiden Kontaktflächen 1 her, welche oberhalb und unterhalb des komprimierten Verbindungselements angeordnet sind und in der Figur nicht gezeigt sind. Während des Verklebens verhindert das Gewebe ein Zerfließen des Flüssigmetalltröpfchens in der Haupterstreckungsebene des Verbindungselements 10, das heißt in der Ebene orthogonal zur Stauchungsrichtung des deformierbaren Teils 11.

Figur 9(a) zeigt einen Querschnitt eines weiteren beispielhaften Verbindungselements 10 im unmontierten Zustand. In der dargestellten Ausgestaltung ist ein elekrisch leitfähiges Teil 6 ist in als Silberpartikel ausgebildet. Drei Silberpartikel sind in einem elektrisch isolierenden Material eingebettet.

Figur 9(b) wird ein Querschnitt des in Figur 9(a) beispielhaft gezeigten Verbindungselements 10 im montierten Zustand dargestellt. Durch das Verkleben der nicht gezeigten Kontaktflächen 1 werden die Silberpartikel durch die Kontaktflächen in einer Richtung orthogonal zur Haupterstreckungsebene des Verbindungselement 10 komprimiert und stellen so einen elektrischen Kontakt zwischen den beiden Kontaktflächen 1 her.

### Bezugszeichenliste:

- 1: - Kontaktflächen
- 2: - elektrisch nicht leitfähige Bereiche
- 3: - elektrisch leitfähige Bereiche
- 4a: - elektrisch leitfähige Fäden
- 4b: - elektrisch nicht leitfähige Fäden
- 5: - elektrisch isolierendes Material
- 6: - elektrisch leitfähiges Teil
- 7: - Ablöseband
- 8: - elektrisches Bauelement
- 9: - Schaltungsträger
- 10: - Verbindungselement
- 11: - deformierbares Teil

## Patentansprüche

1. Kontaktieranordnung umfassend,
mindestens zwei elektrisch leitfähige Kontaktflächen (1), die einander zugewandt angeordnet sind,
zumindest ein flächiges Verbindungselement (10), welches zwischen den zwei Kontaktflächen (1) angeordnet ist, wobei das flächige Verbindungselement (10) mindestens ein elektrisch leitfähiges Teil (6) und ein elektrisch isolierendes Material (5) umfasst, und das mindestens eine zumindest bereichsweise elektrisch leitfähige Teil (6) in dem isolierenden Material (5) eingebettet ist, und
wobei das elektrisch isolierende Material (5) die zwei Kontaktflächen (1) so miteinander verklebt, dass das mindestens eine elektrisch leitfähige Teil (6) durch die zwei Kontaktflächen (1) gestaucht ist und einen elektrischen Kontakt zwischen den zwei Kontaktflächen (1) herstellt.

2. Kontaktieranordnung gemäß Anspruch 1, wobei das elektrisch leitfähige Teil (6) als ein textiles Flächengebilde ausgebildet ist.

3. Kontaktieranordnung gemäß Anspruch 2, wobei das textile Flächengebilde leitfähige Fäden (4a), Drähte oder Litzen aufweist oder daraus besteht.

4. Kontaktieranordnung gemäß Anspruch 3, wobei das textile Flächengebilde elektrisch leitfähige Bereiche (3) und nichtleitfähige Bereiche (2) aufweist.

5. Kontaktieranordnung gemäß Anspruch 4, wobei die elektrisch leitfähigen Bereiche (3) in einem periodischen Muster über das Flächengebilde beabstandet verteilt sind.

6. Kontaktieranordnung gemäß Anspruch 5, wobei die elektrisch leitfähigen Bereiche (3) die Form von Rechtecken, Quadraten, Kreisen, Tori, Kreuzen, Sechsecken oder Achtecken aufweisen.

7. Kontaktieranordnung gemäß Anspruch 5 oder 6, wobei mindestens jeweils ein elektrisch leitfähiger Bereich (3) zwischen jeweils zweien der einander zugewandten Kontaktflächen angeordnet ist.

8. Kontaktieranordnung gemäß einem der Ansprüche 2 bis 7, wobei das textile Flächengebilde als Gewebe, Gelege, Gewirk, Vliesstoff oder Gestrick ausgebildet ist.

9. Kontaktieranordnung gemäß Anspruch 8, wobei das elektrisch leitfähige Teil (6) als Gewebe mit Kettfäden und Schussfäden ausgebildet ist, und wobei die Schussfäden leitfähige Fäden (4a) ausweisen und die Kettfäden nichtleitfähige Fäden (4b) aufweisen, oder die Schussfäden nichtleitfähige Fäden (4b) aufweisen und die Kettfäden leitfähige Fäden (4a) aufweisen.

10. Kontaktieranordnung gemäß einem der vorgehenden Ansprüche, wobei das elektrisch isolierende Material (5) einen Klebstoff und insbesondere einen Thermoplast, einen Duroplast, einen durch Strahlung vernetzter Klebstoff, ein PDMS Derivat oder einen lösungsmittelbasierter Klebstoff aufweist oder daraus besteht.

11. Kontaktieranordnung gemäß einem der vorhergehenden Ansprüche, wobei Normalenvektoren der zwei Kontaktflächen (1) im Wesentlichen parallel zueinander verlaufen.

12. Kontaktieranordnung gemäß einem der vorhergehenden Ansprüche, wobei eine Fläche des flächigen Verbindungselements (10) gleich groß wie oder größer als eine Fläche einer, vorzugsweise jeder, der beiden Kontaktflächen (1) ist.

13. Kontaktieranordnung gemäß einem der vorhergehenden Ansprüche, wobei das elektrisch isolierende Material (5) als Klebefolie oder-film ausgebildet ist, in welche das mindestens eine elektrisch leitfähige Teil (6) eingebettet ist.

14. Kontaktieranordnung umfassend,
mindestens zwei elektrisch leitfähige Kontaktflächen (1), die einander zugewandt angeordnet sind,
zumindest ein flächiges Verbindungselement (10), welches zwischen den zwei Kontaktflächen (1) angeordnet ist, wobei das flächige Verbindungselement (10) mindestens ein elektrisch leitfähiges Teil (6), mindestens ein deformierbares Teil (11) und ein elektrisch isolierendes Material (5) umfasst, und das mindestens eine elektrisch leitfähige Teil (6) und das mindestens eine deformierbare Teil (11) in dem isolierenden Material (5) eingebettet sind, und
wobei das elektrisch isolierende Material (5) die zwei Kontaktflächen (1) so miteinander verklebt, dass das mindestens eine deformierbare Teil (11) durch die zwei Kontaktflächen gestaucht sein kann und das mindestens eine elektrisch leitfähige Teil (6) einen elektrischen Kontakt zwischen den zwei Kontaktflächen (1) herstellt.

15. Kontaktieranordnung gemäß Anspruch 14, wobei das mindestens eine elektrisch leitfähige Teil (6) mindestens ein Flüssigmetalltröpfchen umfasst und das mindestens eine deformierbare Teil (11) ein elektrisch leitfähiges oder nichtleitfähiges, textiles Flächengebilde umfasst.

16. Kontaktieranordnung gemäß Anspruch 14 oder 15, wobei das elektrische leitfähige Teil (6) mindestens ein Metallpartikel, insbesondere ein Silberpartikel, aufweist und das mindestens eine deformierbare Teil (11) Polymere aufweist.

17. Verfahren zum gleichzeitigen mechanischen und elektrischen Verbinden von mindesten zwei einander zugewandten elektrisch leitfähigen Kontaktflächen (1) mittels eines flächigen Verbindungselements (10), welches zwischen den zwei Kontaktflächen (1) angeordnet ist, wobei das flächige Verbindungselement (10) mindestens ein zumindest bereichsweise elektrisch leitfähiges Teil (6) und ein elektrisch isolierendes Material (5) aufweist und das mindestens eine elektrisch leitfähige Teil (6) in dem elektrisch isolierenden Material (5) eingebettet ist,
wobei das elektrisch isolierende Material (5) während einem gegeneinander Pressens der zwei Kontaktflächen (1) in einem fließfähigen Zustand ist und anschließend in einen festen Zustand überführt wird, so dass eine Stauchung des elektrisch leitfähigen Teils (6) durch die zwei Kontaktflächen (1) aufrechterhalten wird und ein elektrischer Kontakt der zwei Kontaktflächen (1) durch das elektrisch leitfähige Teil (6) erhalten wird.

18. Verfahren gemäß Anspruch 17, wobei das flächige Verbindungselement (10) vor dem Verbinden der zwei elektrisch leitfähigen Kontaktflächen (1) von einem Band abgetrennt wird.
